# EUROPEAN PATENT APPLICATION

(11) **EP 4 738 434 A1**
(43) Date of publication of application: **06.05.2026**
(21) Application number: 24857851.0
(22) Date of filing: 16.05.2024
(51) Int. Cl.: H01L 23/367

(54) **CHIP HEAT DISSIPATION ASSEMBLY AND VEHICLE**

(30) Priority: 01.09.2023 CN 202311137997
(71) Applicant: Shenzhen Yinwang Intelligent Technologies Co., Ltd., Shenzhen, Guangdong 518110 (CN)
(72) Inventor: PENG, Yaofeng, Shenzhen, Guangdong 518129 (CN)
(74) Representative: Gill Jennings & Every LLP
(86) International application number: PCT/CN2024/093677
(87) International publication number: WO 2025/044303

(57) **Abstract**

Embodiments of this application relate to the field of heat dissipation technologies, and provide a chip heat dissipation assembly and a vehicle, to reduce stress on a chip while improving a heat dissipation capability of the chip heat dissipation assembly. The chip heat dissipation assembly includes a circuit board, a chip, a heat dissipation structure, and a thermally conductive medium. The chip is located on the circuit board. The heat dissipation structure covers a side that is of the chip and that is away from the circuit board, and is connected to the circuit board. The heat dissipation structure includes a heat dissipation panel, an enclosure part, and a boss part, and the enclosure part and the boss part are located on a side that is of the heat dissipation panel and that is close to the chip. Both the enclosure part and the boss part are connected to the heat dissipation panel, and the enclosure part is disposed around the boss part. Closed space is enclosed by the heat dissipation panel, the enclosure part, the boss part, and the chip, and there is a gap between the boss part and the chip. The thermally conductive medium is filled in the closed space. The thermally conductive medium is in a solid state at a first temperature, and is in a liquid state at a second temperature. The second temperature is higher than the first temperature. The chip heat dissipation assembly is used in the vehicle, to improve a heat dissipation capability of a chip in the vehicle.

## Description

This application claims priority to Chinese Patent Application No. 202311137997.0, filed with the China National Intellectual Property Administration on September 1, 2023 and entitled "CHIP HEAT DISSIPATION ASSEMBLY AND VEHICLE", which is incorporated herein by reference in its entirety.

### TECHNICAL FIELD

This application relates to the field of heat dissipation technologies, and in particular, to a chip heat dissipation assembly and a vehicle.

### BACKGROUND

With continuous improvement of a vehicle automation level, power consumption of a chip used in an internal module of a vehicle increases sharply, and heat dissipation becomes an important challenge to improve computing power of the chip. Whether heat of the chip can be well dissipated directly affects vehicle performance. However, a heat dissipation capability of an existing heat dissipation apparatus for dissipating heat of a chip is poor, and stress on the chip is large. Consequently, working reliability of the chip is low.

### SUMMARY

Embodiments of this application provide a chip heat dissipation assembly and a vehicle, to reduce stress on a chip while improving a heat dissipation capability of the chip heat dissipation assembly.

To achieve the foregoing objectives, the following technical solutions are used in embodiments of this application.

According to a first aspect, a chip heat dissipation assembly is provided. The chip heat dissipation assembly includes a circuit board, a chip, a heat dissipation structure, and a thermally conductive medium. The chip is located on the circuit board. The heat dissipation structure covers a side that is of the chip and that is away from the circuit board, and is connected to the circuit board. The heat dissipation structure includes a heat dissipation panel, an enclosure part, and a boss part, and the enclosure part and the boss part are located on a side that is of the heat dissipation panel and that is close to the chip. Both the enclosure part and the boss part are connected to the heat dissipation panel, and the enclosure part is disposed around the boss part. Closed space is enclosed by the heat dissipation panel, the enclosure part, the boss part, and the chip, and there is a gap between the boss part and the chip. The thermally conductive medium is filled in the closed space. The thermally conductive medium is in a solid state at a first temperature, and is in a liquid state at a second temperature, and the second temperature is higher than the first temperature.

In the chip heat dissipation assembly provided in this embodiment of this application, the chip is located between the heat dissipation structure and the circuit board. The heat dissipation structure includes the heat dissipation panel, the enclosure part, and the boss part. Both the enclosure part and the boss part are located on the side that is of the heat dissipation panel and that is close to the chip, and both the enclosure part and the boss part are connected to the heat dissipation panel. The enclosure part is disposed around the boss part. The closed space is enclosed by the heat dissipation panel, the enclosure part, the boss part, and the chip, to provide accommodating space for the thermally conductive medium.

The thermally conductive medium is in the solid state at the first temperature. In a preparation process of the chip heat dissipation assembly provided in this embodiment of this application, the thermally conductive medium may be assembled at the first temperature. In this way, assembling difficulty of the thermally conductive medium may be low, so that preparation difficulty of the chip heat dissipation assembly can be reduced, and preparation efficiency of the chip heat dissipation assembly is improved.

The thermally conductive medium is in the liquid state at the second temperature. After the thermally conductive medium in the solid state is placed in the closed space, the assembled chip heat dissipation assembly may be placed in an environment whose temperature is the second temperature, so that the thermally conductive medium changes from the solid state to the liquid state, and the thermally conductive medium in the liquid state is filled in the gap between the boss part and the chip. In this way, the thermally conductive medium in the liquid state does not apply stress to the boss part and the chip, thereby helping improve working stability of the chip and increasing a yield rate of the chip heat dissipation assembly.

It may be understood that, even if the chip heat dissipation assembly is taken out from the environment whose temperature is the second temperature, the thermally conductive medium changes from the liquid state to the solid state again. Because a size of a part that is of the thermally conductive medium and that is located in the gap in a direction perpendicular to the circuit board is completely the same as a size of the gap in the direction perpendicular to the circuit board, the thermally conductive medium does not apply stress to the boss part and the chip, and working stability of the chip can still be good.

In some embodiments, the enclosure part includes a first end face away from the heat dissipation panel, the chip includes a second end face away from the circuit board, and the first end face is opposite to the second end face. In this way, a connection manner between the enclosure part and the chip is simple, and a structure of the enclosure part may be simple. This helps simplify a structure of the heat dissipation structure.

In some embodiments, the enclosure part is disposed around an edge of the second end face. In this way, a contact area between the thermally conductive medium and the chip may be large, so that the thermally conductive medium can better absorb heat of the chip, and transfer the heat of the chip to the heat dissipation panel. This helps improve a heat dissipation capability of the chip heat dissipation assembly.

In some embodiments, in a direction perpendicular to the circuit board, a size of the enclosure part is greater than a size of the boss part.

In some embodiments, the boss part includes a third end face facing the chip, the third end face includes a first micro groove, and an extension direction of the first micro groove is parallel to the third end face.

In this embodiment of this application, the first micro groove is formed on the third end face that is of the boss part and that faces the chip, so that infiltration of the thermally conductive medium in the liquid state on the third end face can be improved, and contact thermal resistance between the thermally conductive medium and the boss part can be reduced. This improves thermal conduction efficiency between the thermally conductive medium in the liquid state and the boss part, and improves a heat dissipation capability of the chip heat dissipation assembly.

In some embodiments, the chip includes the second end face away from the circuit board, the second end face includes a second micro groove, and an extension direction of the second micro groove is parallel to the second end face.

In this embodiment of this application, the second micro groove is formed on the second end face of the chip, so that infiltration of the thermally conductive medium in the liquid state on the second end face can be improved, and contact thermal resistance between the thermally conductive medium and the chip can be reduced. This improves thermal conduction efficiency between the thermally conductive medium in the liquid state and the chip, and improves a heat dissipation capability of the chip heat dissipation assembly.

In some embodiments, the chip heat dissipation assembly further includes a sealing structure, and the sealing structure is located between the enclosure part and the chip. The sealing structure is disposed between the enclosure part and the chip, so that the gap between the enclosure part and the chip can be filled when a height of the enclosure part and/or a height of the chip have/has a deviation, to ensure closure of the closed space. In addition, when the thermally conductive medium is in the liquid state, the sealing structure may be configured to avoid a short circuit of the circuit board due to leakage of the thermally conductive medium from the closed space, so that a yield rate of the chip heat dissipation assembly is effectively increased.

In some embodiments, the sealing structure is a porous structure, and diameters of a plurality of holes in the sealing structure are greater than a diameter of an air molecule. In this way, gas in the closed space may be discharged through the sealing structure, so that bubbles are not likely to appear in the thermally conductive medium. This helps ensure heat conduction performance of the thermally conductive medium, and ensure a heat dissipation capability of the chip heat dissipation assembly.

In some embodiments, the thermally conductive medium includes liquid metal. In this embodiment of this application, the thermally conductive medium is liquid metal. Compared with a conventional thermal pad or another silicon-based thermal interface material, the thermally conductive medium may have a higher thermal conductivity, and a smaller thermal resistance at a same thickness, so that a heat dissipation capability of the chip heat dissipation assembly can be significantly improved.

According to a second aspect, a preparation method of a chip heat dissipation assembly is provided. The preparation method includes: providing a heat dissipation structure, where the heat dissipation structure includes a heat dissipation panel, an enclosure part, and a boss part, both the enclosure part and the boss part are connected to the heat dissipation panel, and the enclosure part is disposed around the boss part, and an accommodating groove is formed among the enclosure part, the boss part, and the heat dissipation panel; placing the thermally conductive medium in a solid state in the accommodating groove; providing a circuit board and a chip, and disposing the chip on the circuit board; and connecting the heat dissipation structure to the circuit board. The heat dissipation panel covers a side that is of the chip and that is away from the circuit board. The enclosure part and the boss part are located on a side that is of the heat dissipation panel and that is close to the chip. Closed space is enclosed by the heat dissipation panel, the enclosure part, the boss part, and the chip, and there is a gap between the boss part and the chip. The thermally conductive medium is filled in the closed space. The thermally conductive medium is in a solid state at a first temperature, and is in a liquid state at a second temperature, and the second temperature is higher than the first temperature.

According to a third aspect, a vehicle is provided. The vehicle includes a vehicle body and the chip heat dissipation assembly according to any one of the foregoing embodiments. The chip heat dissipation assembly is located inside the vehicle body.

For technical effects brought in by any design manner in the second aspect and the third aspect, refer to technical effects brought in by different design manners in the first aspect. Details are not described herein again.

### BRIEF DESCRIPTION OF DRAWINGS

To describe technical solutions in this application more clearly, the following briefly describes accompanying drawings used for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual time sequence of a signal, and the like in embodiments of this application.
FIG. 1 is a diagram of a structure of a heat dissipation assembly according to a related technology;
FIG. 2 is a diagram of a structure of a chip heat dissipation assembly according to an embodiment of this application;
FIG. 3 is a diagram of a structure of another chip heat dissipation assembly according to an embodiment of this application;
FIG. 4 is a diagram of a structure of an enclosure part, a boss part, and a thermally conductive medium according to an embodiment of this application;
FIG. 5 is a diagram of a structure of still another chip heat dissipation assembly according to an embodiment of this application;
FIG. 6 is a diagram of a structure of yet another chip heat dissipation assembly according to an embodiment of this application;
FIG. 7 is a diagram of a second end face according to an embodiment of this application;
FIG. 8 is a flowchart of a preparation method of a chip heat dissipation assembly according to an embodiment of this application;
FIG. 9 is a structural state diagram corresponding to step S100 in the flowchart shown in FIG. 8;
FIG. 10 is a structural state diagram corresponding to step S200 in the flowchart shown in FIG. 8; and
FIG. 11 is a diagram of a structure of a vehicle according to an embodiment of this application.

### DESCRIPTION OF EMBODIMENTS

The following describes the technical solutions in embodiments of this application with reference to the accompanying drawings in embodiments of this application. In descriptions of this application, unless otherwise specified, "/" indicates an "or" relationship between associated objects. For example, A/B may indicate A or B.

"And/or" in this application describes only an association relationship between associated objects and indicates that three relationships may exist. For example, A and/or B may indicate the following three cases: Only A exists, both A and B exist, and only B exists. A and B may be singular or plural.

In the descriptions of this application, unless otherwise specified, "a plurality of" means two or more. At least one of the following items (pieces) or a similar expression thereof indicates any combination of these items, including a single item (piece) or any combination of a plurality of items (pieces). For example, at least one (piece) of a, b, or c may represent: a, b, c, a-b, a-c, b-c, or a-b-c, where a, b, and c may be singular or plural.

To clearly describe the technical solutions in embodiments of this application, terms such as "first" and "second" are used in embodiments of this application to distinguish between same items or similar items that have basically the same functions and purposes. A person skilled in the art may understand that the terms such as "first" and "second" do not limit a quantity or an execution sequence, and the terms such as "first" and "second" do not indicate a definite difference.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

Generally, autonomous driving levels may be classified into six levels (namely, level L0 to level L5). Level L0: no autonomous driving, where only warnings are provided, and vehicle control is not intervened in. Level L1: driver assistance, where an independent driver assistant system is available, supporting lane assistance and adaptive cruise control. Level L2: partially autonomous driving, where a plurality of driver assistant systems are integrated and controlled, road conditions need to be monitored, and emergencies need to be intervened in. Level L3: conditional automation, where an autonomous driving function is basically implemented, road conditions need to be monitored, and emergencies need to be intervened in. L4: highly autonomous driving, where a driver is required to intervene sometimes. L5: a fully autonomous driving phase, where a vehicle completes all vehicle control operations.

Each time the level of autonomous driving increases by one level, computing power required by a system on chip (System On Chip, SOC) in the vehicle increases exponentially. As a result, power consumption of the system on chip increases significantly, heat of the chip increases sharply, and heat dissipation difficulty of the chip also increases significantly.

In addition, with the development of electric vehicles, an electrical/electronic architecture (Electrical/Electronic Architecture, EEA) of the electric vehicle will evolve from distributed to domain-based centralized, and finally to vehicle-based centralized. Electronic control units (electronic control units, ECUs) with different functions are centralized on a central computing platform. As a result, power consumption of a chip in the central computing platform is very high, and heat dissipation difficulty of a system on chip is further increased.

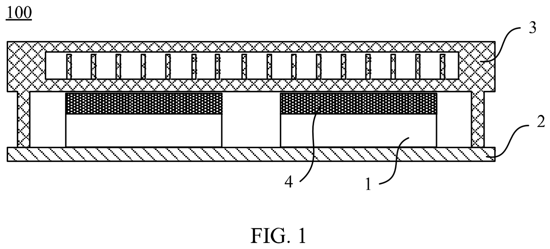

FIG. 1 is a diagram of a structure of a heat dissipation assembly 100 according to a related technology. As shown in FIG. 1, the heat dissipation assembly 100 includes a chip 1, a circuit board 2, a heat dissipation structure 3, and a thermal interface material (thermal interface material, TIM) layer 4.

The chip 1 is located on the circuit board 2, the heat dissipation structure 3 covers a side that is of the chip 1 and that is away from the circuit board 2, and the heat dissipation structure 3 is connected to the circuit board 2. The thermal interface material layer 4 is located between the chip 1 and the heat dissipation structure 3. Due to a height tolerance of the chip 1 and a height tolerance of the heat dissipation structure 3, a size of a gap between the chip 1 and the heat dissipation structure 3 in a direction perpendicular to the circuit board 2 reaches 1 millimeter to 2 millimeters. The thermal interface material layer 4 is filled in the gap between the chip 1 and the heat dissipation structure 3, and is in contact with both the chip 1 and the heat dissipation structure 3. In this way, a thickness of the thermal interface material layer 4 is large, and thermal resistance of the thermal interface material layer 4 is also large, so that a large temperature difference (for example, above 12 degrees Celsius) is generated on the thermal interface material layer 4. As a result, when chip power consumption of the chip 1 increases, heat dissipation performance of the heat dissipation assembly 100 decreases sharply.

To improve heat dissipation performance of the heat dissipation assembly 100, the thermal interface material layer 4 may be a material with high thermal conduction efficiency. However, the material with high thermal conduction efficiency usually has high hardness. When the thermal interface material layer is placed between the heat dissipation structure 3 and the chip 1, stress applied by the thermal interface material layer to the chip is correspondingly large, which severely affects working stability of the chip.

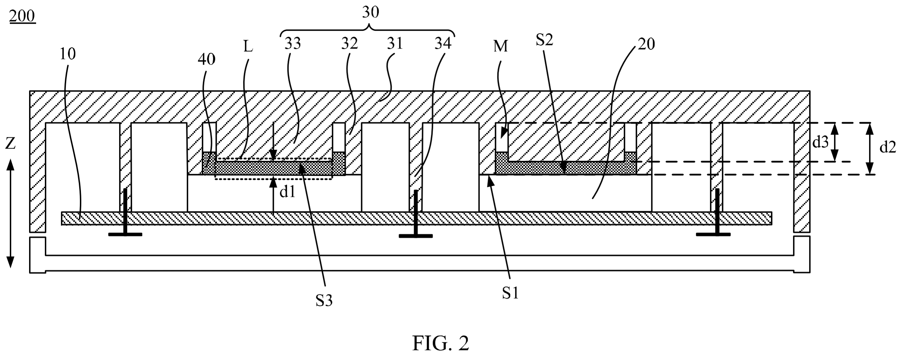

In view of this, an embodiment of this application provides a chip heat dissipation assembly 200. As shown in FIG. 2, the chip heat dissipation assembly 200 includes a circuit board 10, a chip 20, a heat dissipation structure 30, and a thermally conductive medium 40. The chip 20 is located on the circuit board 10. The heat dissipation structure 30 covers a side that is of the chip 20 and that is away from the circuit board 10, and is connected to the circuit board 10. The heat dissipation structure 30 includes a heat dissipation panel 31, an enclosure part 32, and a boss part 33. Both the enclosure part 32 and the boss part 33 are located on a side that is of the heat dissipation panel 31 and that is close to the chip 20. Both the enclosure part 32 and the boss part 33 are connected to the heat dissipation panel 31, and the enclosure part 32 is disposed around the boss part 33. Closed space M is enclosed by the heat dissipation panel 31, the enclosure part 32, the boss part 33, and the chip 20. There is a gap between the boss part 33 and the chip 20. The thermally conductive medium 40 is filled in the closed space M. The thermally conductive medium 40 is in a solid state at a first temperature, and is in a liquid state at a second temperature. The second temperature is higher than the first temperature.

For example, the circuit board 10 may be a printed circuit board (printed circuit board, PCB).

It may be understood that the chip 20 is located on the circuit board 10, and the chip 20 should be electrically connected to the circuit board 10.

In some examples, the chip heat dissipation assembly 200 may include one chip 20. In this case, a quantity of chips 20 in the chip heat dissipation assembly 200 is small, and an area occupied by the chips 20 on the circuit board 10 is small. This helps reduce a size of the circuit board 10 and improve an integration level of the circuit board 10.

In some other examples, as shown in FIG. 2, the chip heat dissipation assembly 200 may include a plurality of chips 20. In this case, the plurality of chips 20 may share computing power, so that power consumption of each chip 20 may be small. This helps reduce heat dissipation difficulty of the chip heat dissipation assembly 200, and improve performance of the chip heat dissipation assembly 200. When the chip heat dissipation assembly 200 has a plurality of chips 20, a specific quantity of chips 20 in embodiments of this application is not limited. For example, the quantity of chips 20 may be 2, 4, 6, or more.

When the chip heat dissipation assembly 200 includes a plurality of chips 20, as shown in FIG. 2, the heat dissipation structure 30 may include a plurality of enclosure parts 32, and each chip 20 corresponds to one enclosure part 32.

It may be understood that, in addition to the foregoing chip 20, another electronic component may be further disposed on the circuit board 10, and the another electronic component may be electrically connected to the chip 20 through a trace in the circuit board 10.

For example, the heat dissipation panel 31 may be a thin copper plate with good heat conduction performance, a thin aluminum plate with a welded heat pipe, a thin flat heat pipe, a graphene thin sheet, or the like. This is not specifically limited in this application.

In some examples, the enclosure part 32 and the heat dissipation panel 31 may be of an integrated structure. In this case, materials of the enclosure part 32 and the heat dissipation panel 31 are the same, and a gap is not likely to appear at a joint between the enclosure part 32 and the heat dissipation panel 31. This helps improve reliability of a connection between the enclosure part 32 and the heat dissipation panel 31, and improve sealing performance of the closed space M.

In some other examples, the enclosure part 32, the boss part 33, and the heat dissipation panel 31 may be of an integrated structure. In this case, materials of the enclosure part 32, the boss part 33, and the heat dissipation panel 31 are the same, and stability of a connection between the enclosure part 32 and the heat dissipation panel 31 and a connection between the boss part 33 and the heat dissipation panel 31 can be good. This helps reduce costs of the chip heat dissipation assembly 200, and improve use stability of the chip heat dissipation assembly 200.

In some examples, as shown in FIG. 2, the heat dissipation structure 30 further includes a connection part 34. The connection part 34 is located on a side that is of the heat dissipation panel 31 and that is close to the circuit board 10, and is connected to the heat dissipation panel 31. The connection part 34 is connected to the circuit board 10.

In embodiments of this application, the heat dissipation panel 31 is connected to and fastened to the circuit board 10 through the connection part 34, so that a connection between the enclosure part 32, the chip 20, and the heat dissipation panel 31 is stable. This helps avoid a problem of misalignment between the enclosure part 32 and the chip 20 due to misalignment between the heat dissipation structure and the circuit board or misalignment between the heat dissipation panel and the circuit board, and further avoid a problem that the closed space is damaged and the thermally conductive medium 40 in a liquid state leaks from the closed space. In this way, working stability of the chip heat dissipation assembly is ensured.

For example, the connection part 34 may be fastened to the circuit board 10 through a screw.

In the chip heat dissipation assembly 200 provided in this embodiment of this application, the chip 20 is located between the circuit board 10 and the heat dissipation structure 30, the heat dissipation structure 30 includes the heat dissipation panel 31, the enclosure part 32, and the boss part 33, both the enclosure part 32 and the boss part 33 are located on a side that is of the heat dissipation panel 31 and that is close to the chip 20, and both the enclosure part 32 and the boss part 33 are connected to the heat dissipation panel 31. The enclosure part 32 is disposed around the boss part 33. The closed space M is enclosed by heat dissipation panel 31, the enclosure part 32, the boss part 33, and the chip 20, to provide accommodating space for the thermally conductive medium 40.

The thermally conductive medium 40 is in the solid state at the first temperature. In a preparation process of the chip heat dissipation assembly 200 provided in this embodiment of this application, the thermally conductive medium 40 may be assembled at the first temperature. In this way, assembling difficulty of the thermally conductive medium 40 may be low, so that preparation difficulty of the chip heat dissipation assembly 200 can be reduced, and preparation efficiency of the chip heat dissipation assembly 200 is improved.

The thermally conductive medium 40 is in the liquid state at the second temperature. After the thermally conductive medium 40 in the solid state is placed in the closed space M, the assembled chip heat dissipation assembly 200 may be placed in an environment whose temperature is the second temperature, so that the thermally conductive medium 40 changes from the solid state to the liquid state, and the thermally conductive medium 40 in the liquid state is filled in the gap between the boss part 33 and the chip 20. In this way, the thermally conductive medium 40 in the liquid state does not apply stress to the boss part 33 and the chip 20, thereby helping improve working stability of the chip 20 and increasing a yield rate of the chip heat dissipation assembly 200.

It may be understood that, even if the chip heat dissipation assembly 200 is taken out from the environment whose temperature is the second temperature, the thermally conductive medium 40 changes from the liquid state to the solid state again. Because a size of a part that is of the thermally conductive medium 40 and that is located in a gap L in a direction perpendicular to the circuit board 10 is completely the same as a size of the gap L in the direction perpendicular to the circuit board 10, the thermally conductive medium 40 does not apply stress to the boss part 33 and the chip 20, and working stability of the chip 20 can still be good.

In some examples, still refer to FIG. 2. A size d1 of the gap L in the direction (a Z direction shown in FIG. 2) perpendicular to the circuit board 10 is greater than or equal to 0.1 mm (millimeter), and is less than or equal to 1 mm. For example, the size d1 of the gap L in the direction perpendicular to the circuit board 10 is 0.1 mm, 0.2 mm, 0.3 mm, 0.4 mm, 0.5 mm, 0.6 mm, 0.7 mm, 0.8 mm, 0.9 mm, 1 mm, or the like.

In this way, the size d1 of the gap L in the direction Z perpendicular to the circuit board 10 is not very large, so that a thickness of the thermally conductive medium 40 located in the boss part 33 and the chip 20 may be small. This helps reduce a thermal resistance value of the thermally conductive medium 40, and improve thermal conduction efficiency of the thermally conductive medium 40. In addition, the size d1 of the gap L in the direction perpendicular to the circuit board 10 is not very small. This helps reduce preparation requirements of the heat dissipation structure 30 and the chip 20, and improve preparation efficiency of the chip heat dissipation assembly 200.

In some examples, as shown in FIG. 2, the thermally conductive medium 40 may occupy all of the closed space M, in other words, the closed space M is filled up with the thermally conductive medium 40. In this way, the thermally conductive medium 40, the heat dissipation panel 31, the enclosure part 32, the boss part 33, and the chip 20 may have large contact areas, so that heat of the chip 20 can be better transferred to the heat dissipation panel 31, the enclosure part 32, and the boss part 33. In this way, the heat of the chip 20 can be dissipated to the environment through the heat dissipation panel 31 more quickly, and heat dissipation performance of the chip heat dissipation assembly 200 is effectively ensured.

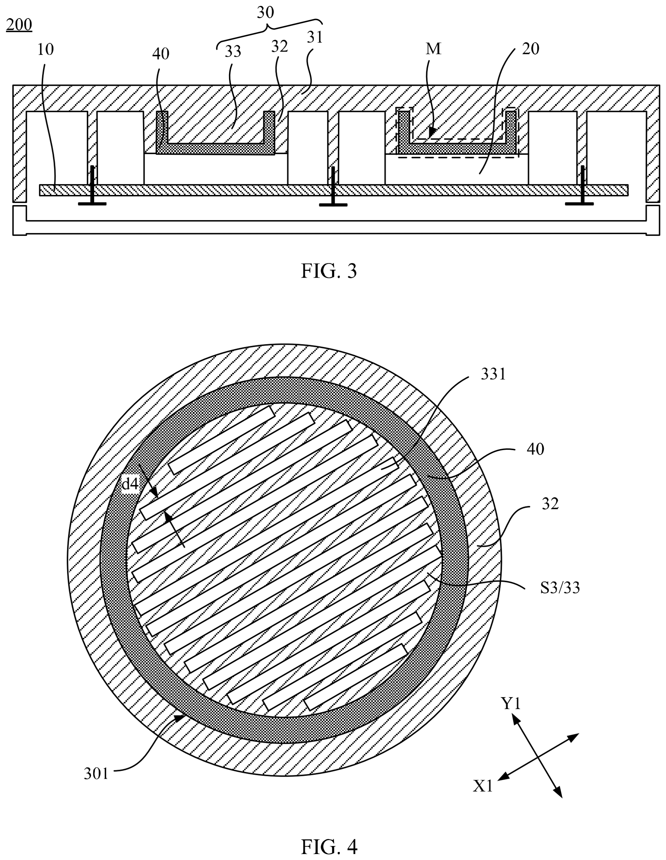

In some other examples, as shown in FIG. 3, the thermally conductive medium 40 occupies a part of the closed space M. In other words, the thermally conductive medium 40 may fill only a part of the closed space M. In this way, when the thermally conductive medium 40 is in the liquid state, the thermally conductive medium 40 may flow in the closed space M. When the thermally conductive medium 40 is in contact with the chip 20, the thermally conductive medium 40 generates small stress on the chip 20. This helps ensure working stability of the chip 20, and increase a yield rate of the chip heat dissipation assembly 200.

In some examples, the thermally conductive medium 40 may be liquid metal. The liquid metal is an amorphous metal, and the liquid metal may be considered as a mixture of a positive ion fluid and a free electron gas.

In this embodiment of this application, the thermally conductive medium 40 is liquid metal. Compared with a conventional thermal pad or another silicon-based thermal interface material, the thermally conductive medium 40 may have a higher thermal conductivity, and a smaller thermal resistance at a same thickness, so that a heat dissipation capability of the chip heat dissipation assembly 200 can be significantly improved.

A melting point of the liquid metal can be adjusted by adjusting a formula of the liquid metal. In some embodiments, the melting point of the liquid metal may be 35 degrees Celsius to 80 degrees Celsius. For example, the melting point of the liquid metal may be 35 degrees Celsius, 50 degrees Celsius, 60 degrees Celsius, 70 degrees Celsius, or 80 degrees Celsius.

In this way, the melting point of the liquid metal is not very low, and the liquid metal may be in the solid state at a normal temperature, so that the thermally conductive medium 40 can be easily assembled into the closed space M, an assembling environment requirement of the thermally conductive medium 40 is reduced, assembling difficulty of the chip heat dissipation assembly 200 is reduced, and preparation efficiency of the chip heat dissipation assembly 200 is improved. In addition, the melting point of the liquid metal is not very high, so that when the chip in the chip 20 is in a working state, the thermally conductive medium 40 may change to the liquid state earlier, and heat generated by the chip 20 is transferred to an external environment more quickly through the heat dissipation panel 31, to avoid a case in which chip performance is affected due to a very high temperature of the chip 20.

It may be understood that, different functions of the chip correspond to different power consumption, and different heat is generated accordingly. Therefore, the melting point of the liquid metal in this embodiment of this application is not limited to the range provided in the foregoing embodiments.

In some examples, the first temperature is less than a melting point value of the liquid metal, and the second temperature is greater than or equal to the melting point value of the liquid metal.

The following describes in detail structures of the enclosure part 32 and the boss part 33 in the heat dissipation structure 30 with reference to FIG. 2 and FIG. 4.

In some embodiments, still refer to FIG. 2. The enclosure part 32 includes a first end face S1 away from the heat dissipation panel 31. The chip includes a second end face S2 away from the circuit board 10. The first end face S1 is opposite to the second end face S2. In this way, a connection manner between the enclosure part 32 and the chip 20 is simple, and a structure of the enclosure part 32 may be simple. This helps simplify a structure of the heat dissipation structure 30.

In some examples, the enclosure part 32 may be disposed around an edge of the second end face S2. In this way, a contact area between the thermally conductive medium 40 and the chip 20 may be large, so that the thermally conductive medium 40 can better absorb heat of the chip 20, and transfer the heat of the chip 20 to the heat dissipation panel 31. This helps improve a heat dissipation capability of the chip heat dissipation assembly 200.

In this case, for example, an outer edge of a projection of the enclosure part 32 on the circuit board 10 may completely or partially overlap an edge of a projection of the chip 20 on the circuit board 10.

For example, the projection of the chip 20 on the circuit board 10 may be rectangular. The projection of the enclosure part 32 on the circuit board 10 may be in a circular ring shape or a square ring shape.

As shown in FIG. 2, in some embodiments, the enclosure part 32 may be disposed around one boss part 33. In this way, a shape of the closed space M enclosed by the heat dissipation panel 31, the enclosure part 32, the boss part 33, and the chip 20 may be simple, and the thermally conductive medium 40 in the solid state may be more easily assembled into the closed space M. This helps further reduce assembling difficulty of the chip heat dissipation assembly 200, and improve preparation efficiency of the chip heat dissipation assembly 200. In addition, such disposing further helps simplify the heat dissipation structure 30, reduce preparation difficulty of the heat dissipation structure 30, and improve preparation efficiency of the heat dissipation structure 30.

In view of this, in some examples, as shown in FIG. 4, a groove 301 may be formed between the boss part 33 and the enclosure part 32, and a projection of the groove 301 on the circuit board 10 is in a circular ring shape. In this way, when the thermally conductive medium 40 in the solid state is placed in the groove 301 in the boss part 33 and the enclosure part 32, even if a size of the thermally conductive medium 40 in the solid state has a deviation, the thermally conductive medium 40 in the solid state may be easily placed in the groove 301.

Certainly, in some other embodiments, the enclosure part 32 may alternatively be disposed around a plurality of boss parts 33.

In some embodiments, still refer to FIG. 2. In a direction Z perpendicular to the circuit board 10, a size d2 of the enclosure part 32 is greater than a size d3 of the boss part 33. A specific value of the size d2 of the enclosure part 32 in the direction Z perpendicular to the circuit board 10 and a specific value of the size d3 of the boss part 33 in the direction Z perpendicular to the circuit board 10 are not limited in embodiments of this application, and may be designed according to an actual requirement.

Certainly, in some other embodiments, in the direction Z perpendicular to the circuit board 10, the size d2 of the enclosure part 32 may alternatively be less than or equal to the size d3 of the boss part 33.

In some examples, as shown in FIG. 2 and FIG. 4, the boss part 33 includes a third end face S3 facing the chip 20. As shown in FIG. 4, the third end face S3 includes a first micro groove 331, and an extension direction X1 of the first micro groove 331 is parallel to the third end face S3. In a first target direction Y1 perpendicular to the extension direction X1 of the first micro groove 331, a size d4 of the first micro groove 331 is less than 1 millimeter.

In some examples, the third end face S3 may be circular, elliptical, rectangular, or the like.

In some examples, the third end face S3 may include a plurality of first micro grooves 331. In this case, a specific quantity of first micro grooves 331 is not limited in embodiments of this application, and may be designed according to an actual requirement. When the third end face S3 includes a plurality of first micro grooves 331, extension directions X1 of the plurality of first micro grooves 331 may be the same or different.

A specific value of a size of the first micro groove 331 in the extension direction X1, a specific value of a size of the first micro groove 331 in the first target direction Y1, and a specific value of a depth of the first micro groove 331 are not limited in embodiments of this application, and may be designed according to an actual requirement.

When the third end face S3 includes a plurality of first micro grooves 331, sizes of the plurality of first micro grooves 331 in the extension direction X1 may be the same or different. Similarly, when the third end face S3 includes a plurality of first micro grooves 331, sizes of the plurality of first micro grooves 331 in the first target direction Y1 may be the same or different. When the third end face S3 includes a plurality of first micro grooves 331, depths of the plurality of first micro grooves 331 may be the same or different.

In this embodiment of this application, the first micro groove 331 is formed on the third end face S3 that is of the boss part 33 and that faces the chip 20, so that infiltration of the thermally conductive medium 40 in the liquid state on the third end face S3 can be improved, and contact thermal resistance between the thermally conductive medium 40 and the boss part 33 can be reduced. This improves thermal conduction efficiency between the thermally conductive medium 40 in the liquid state and the boss part 33, and improves a heat dissipation capability of the chip heat dissipation assembly 200.

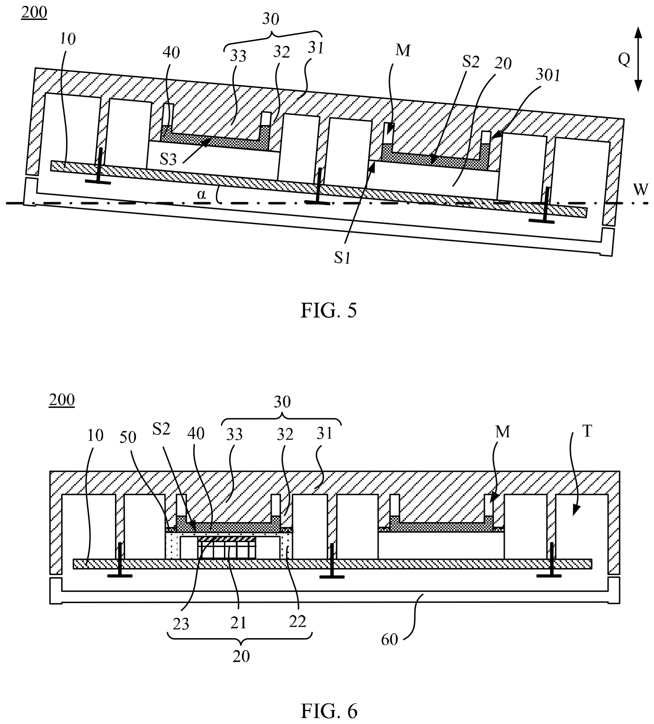

In some examples, as shown in FIG. 5, in a gravity direction Q, the chip 20 is located above the circuit board 10, and when a tilt angle α of the circuit board 10 relative to a horizontal plane W is less than or equal to a preset angle, the thermally conductive medium 40 is in contact with both opposite surfaces between the boss part 33 and the chip 20.

A specific value of the preset angle is not limited in embodiments of this application, and may be designed according to an actual requirement. For example, the preset angle may be 30 degrees, 40 degrees, 50 degrees, or larger.

In this way, when the chip heat dissipation assembly 200 is tilted, the thermally conductive medium 40 may always be in contact with the boss part 33 and the chip 20, to ensure that the thermally conductive medium 40 can continuously and efficiently transmit heat generated by the chip 20 to the heat dissipation panel 31.

In some embodiments, as shown in FIG. 6, the chip heat dissipation assembly 200 may further include a sealing structure 50, and the sealing structure 50 is located between the enclosure part 32 and the chip 20.

The sealing structure 50 is disposed between the enclosure part 32 and the chip 20, so that the gap between the enclosure part 32 and the chip 20 can be filled when a height of the enclosure part 32 and/or a height of the chip 20 have/has a deviation, to ensure closure of the closed space M. In addition, when the thermally conductive medium 40 is in the liquid state, the sealing structure 50 may be configured to avoid a short circuit of the circuit board 10 due to leakage of the thermally conductive medium 40 from the closed space M, so that a yield rate of the chip heat dissipation assembly 200 is effectively increased.

In some embodiments, the sealing structure 50 may be a porous structure, and diameters of a plurality of holes in the sealing structure 50 are greater than a diameter of an air molecule. In this way, gas in the closed space M may be discharged through the sealing structure 50, so that bubbles are not likely to appear in the thermally conductive medium 40. This helps ensure heat conduction performance of the thermally conductive medium 40, and ensure a heat dissipation capability of the chip heat dissipation assembly 200. It may be understood that, due to existence of surface tension, particles (for example, ions, atoms, or molecules) in the thermally conductive medium in the liquid state are pulled to each other, so that the thermally conductive medium in the liquid state does not pass through the sealing structure 50.

For example, a material of the sealing structure 50 may include rubber, foam, or the like.

In some embodiments, as shown in FIG. 6, the chip 20 includes a wafer 21 and a protective cover 22. The wafer 21 is located on the circuit board 10. The protective cover 22 covers a side that is of the wafer 21 and that is away from the circuit board 10. The protective cover 22 is configured to protect the wafer 21, to prevent the wafer 21 from being damaged due to an external force.

In some examples, there may be one wafer 21 in the chip 20. In some other examples, the chip 20 may include a plurality of wafers 21.

In some examples, the chip 20 may further include a substrate (not shown), and the wafer 21 is integrated on the substrate. The protective cover 22 may be connected to the substrate. The wafer 21 may be electrically connected to the substrate through a first connection structure. An electrically conductive layer may be formed in the substrate, and the electrically conductive layer includes a routing structure. The substrate may establish a signal path between wafers or between a wafer and another electronic component through the routing structure.

When the wafer is disposed on the substrate, a flip-chip ball grid array (flip-chip ball grid array, FCBGA) technology may be used. In some other packaging structures, the wafer may alternatively be disposed on the substrate by using a wire bonding (wire bonding) technology. The substrate has a plurality of optional structures. For example, the substrate may be a packaging substrate (substrate), or may be a redistribution layer (redistribution layer, RDL) substrate obtained by using a redistribution process, or may be an interposer (Interposer). Certainly, the substrate may alternatively be another structure. The substrate may be electrically connected to the circuit board through a second connection structure. For example, the second connection structure may be a ball grid array (ball grid array, BGA), or may be a plurality of copper pillar bumps (copper pillar bumps) arranged in an array.

In some examples, as shown in FIG. 6, a projection of the wafer 21 on the circuit board 10 is located inside a projection of the enclosure part 32 on the circuit board 10. In this way, the projection of the wafer 21 on the circuit board 10 may be located inside a projection of the thermally conductive medium 40 on the circuit board 10, and heat generated by the wafer 21 may be quickly transmitted to the thermally conductive medium 40 through the protective cover 22, so that heat dissipation efficiency of the chip heat dissipation assembly 200 is effectively improved.

In some other examples, still as shown in FIG. 6, the projection of the wafer 21 on the circuit board 10 may be located inside a projection of the boss part 33 on the circuit board 10. In this way, the heat generated by the wafer 21 may be quickly transferred to the thermally conductive medium 40 through the protective cover 22, then is quickly transferred to the boss part 33 through the thermally conductive medium 40, and is transferred to the heat dissipation panel 31 through the boss part 33. This effectively shortens a heat transfer path, and improves heat dissipation efficiency of the chip heat dissipation assembly 200.

In some examples, as shown in FIG. 6, the chip 20 further includes a thermally conductive layer 23, and the thermally conductive layer 23 is located between the protective cover 22 and the wafer 21. In this way, the heat generated by the wafer 21 may be transferred to the protective cover 22 through the thermally conductive layer 23. This effectively improves heat transfer efficiency between the wafer 21 and the protective cover 22, and further improves a heat dissipation capability of the chip heat dissipation assembly 200.

In some other embodiments, the chip 20 may include only a wafer. In this case, the enclosure part 32, the boss part 33, and the heat dissipation panel 31 may enclose closed space M with the wafer.

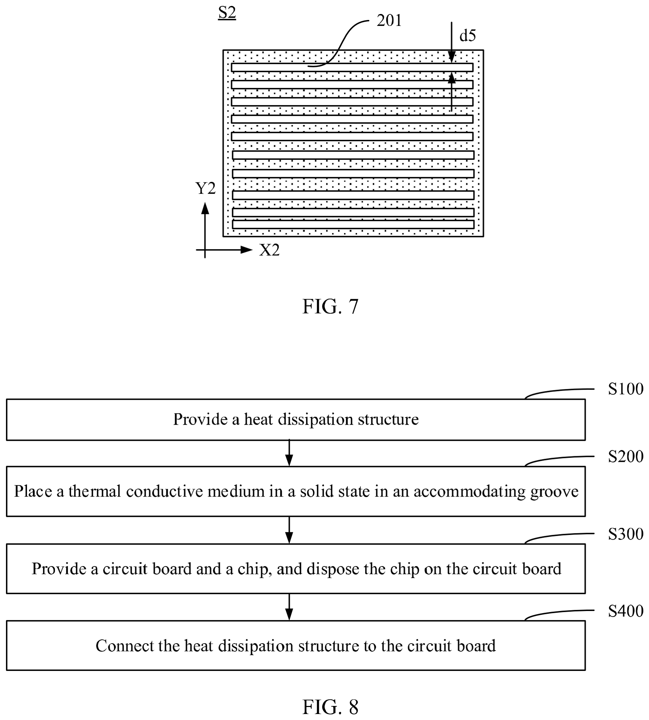

In some embodiments, as shown in FIG. 7, the chip 20 may include a second end face S2 away from the circuit board 10, the second end face S2 includes a second micro groove 201, an extension direction X2 of the second micro groove 201 is parallel to the second end face S2, and in a second target direction Y2 perpendicular to the extension direction X2 of the second micro groove 201, a size d5 of the second micro groove 201 is less than 1 millimeter.

In some examples, the second end face S2 may include a plurality of second micro grooves 201. In this case, a specific quantity of second micro grooves 201 is not limited in embodiments of this application, and may be designed according to an actual requirement. When the second end face S2 includes a plurality of second micro grooves 201, extension directions X2 of the plurality of second micro grooves 201 may be the same or different.

A specific value of a size of the second micro groove 201 in the extension direction X2, a specific value of a size of the second micro groove 201 in the second target direction Y2, and a specific value of a depth of the second micro groove 201 are not limited in embodiments of this application, and may be designed according to an actual requirement.

It may be understood that, when the chip includes the protective cover 22, the second end face S2 that is of the chip 20 and that is away from the circuit board 10 may be a surface that is of the protective cover 22 and that is away from the circuit board 10.

In this embodiment of this application, the second micro groove 201 is formed on the second end face S2 of the chip 20, so that infiltration of the thermally conductive medium 40 in the liquid state on the second end face S2 can be improved, and contact thermal resistance between the thermally conductive medium 40 and the chip 20 can be reduced. This improves thermal conduction efficiency between the thermally conductive medium 40 in the liquid state and the chip 20, and improves a heat dissipation capability of the chip heat dissipation assembly 200.

In some embodiments, as shown in FIG. 6, the chip heat dissipation assembly 200 may further include a lower housing 60. The lower housing 60 is located on a side of the chip 20 of the circuit board 10. The lower housing 60 is connected to the heat dissipation panel 31, to form a chamber T. Both the circuit board 10 and the chip 20 are located in the chamber T.

In this embodiment of this application, the lower housing 60 is connected to the heat dissipation panel 31, to form the chamber T. Both the circuit board 10 and the chip 20 are located in the chamber T, so that the circuit board 10 and the chip 20 can be protected through the heat dissipation panel 31 and the lower housing 60.

As shown in FIG. 8, an embodiment of this application further provides a preparation method of the chip heat dissipation assembly 200. The preparation method includes step S100 to step S400.

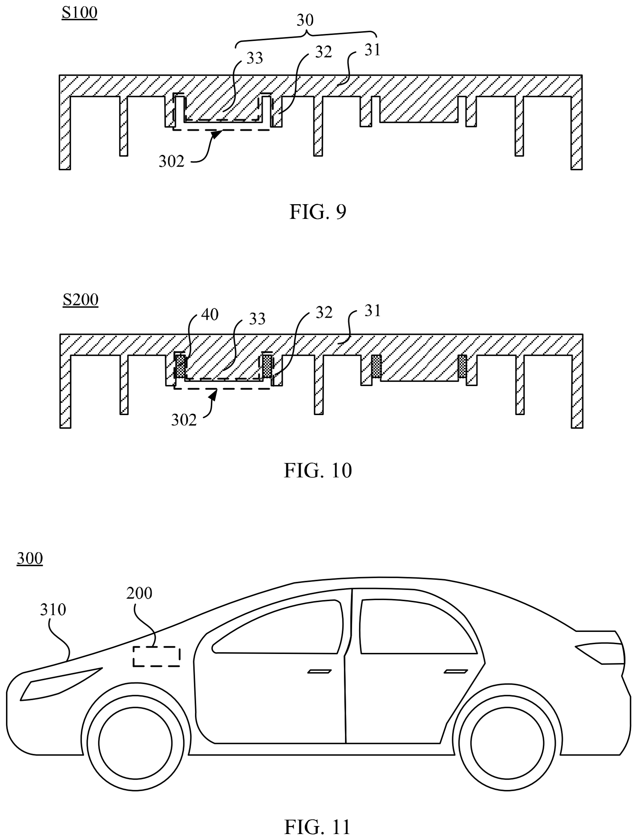

S100: As shown in FIG. 9, provide a heat dissipation structure 30, where the heat dissipation structure 30 includes a heat dissipation panel 31, an enclosure part 32, and a boss part 33, both the enclosure part 32 and the boss part 33 are connected to the heat dissipation panel 31, and the enclosure part 32 is disposed around the boss part 33. An accommodating groove 302 is formed among the enclosure part 32, the boss part 33, and the heat dissipation panel 31.

S200: As shown in FIG. 10, place a thermally conductive medium 40 in a solid state in the accommodating groove 302.

In some examples, as shown in FIG. 10, a volume of the thermally conductive medium 40 in the solid state may be less than a volume of the accommodating groove 302. In some other examples, a volume of the thermally conductive medium 40 in the solid state may be equal to a volume of the accommodating groove 302.

S300: As shown in FIG. 6, provide a circuit board 10 and a chip 20, and dispose the chip 20 on the circuit board 10.

S400: As shown in FIG. 6, connect the heat dissipation structure 30 to the circuit board 10. In this case, the heat dissipation structure 30 covers a side that is of the chip 20 and that is away from the circuit board 10. The enclosure part 32 and the boss part 33 are located on a side that is of the heat dissipation panel 31 and that is close to the chip 20. Closed space M is enclosed by the heat dissipation panel 31, the enclosure part 32, the boss part 33, and the chip 20, and there is a gap L between the boss part 33 and the chip 20. The thermally conductive medium 40 is filled in the closed space M. The thermally conductive medium 40 is in a solid state at a first temperature, and is in a liquid state at a second temperature. The second temperature is higher than the first temperature.

For example, after the heat dissipation structure 30 is connected to the circuit board 10, the chip heat dissipation assembly 200 may be further placed in a high-temperature chamber for a period of time, so that the thermally conductive medium 40 changes from a solid state to a liquid state and is in contact with the chip 20.

Beneficial effects that can be achieved by the preparation method of the chip heat dissipation assembly 200 provided in this embodiment of this application are the same as beneficial effects that can be achieved by the chip heat dissipation assembly 200 provided in any one of the foregoing embodiments. Details are not described herein again.

An embodiment of this application further provides a vehicle. As shown in FIG. 11, the vehicle 300 includes a vehicle body 310 and the chip heat dissipation assembly 200 described in any one of the foregoing embodiments. The chip heat dissipation assembly 200 is located inside the vehicle body 310.

It may be understood that FIG. 11 merely shows an example of disposition positions of the vehicle body 310 and the chip heat dissipation assembly 200. Actually, a structure of the vehicle body 310 may be different from a structure of the vehicle body 310 in FIG. 11, and a disposition position of the chip heat dissipation assembly 200 may also be different from a disposition position of the chip heat dissipation assembly 200 in FIG. 11. A specific structure of the vehicle body 310 and a disposition position of the chip heat dissipation assembly 200 are not limited in embodiments of this application, provided that the chip heat dissipation assembly 200 is disposed inside the vehicle body 310.

The vehicle may be but is not limited to a pure electric vehicle/battery electric vehicle (pure electric vehicle/battery electric vehicle, PEV/BEV), a hybrid electric vehicle (hybrid electric vehicle, HEV), a range-extended electric vehicle (range-extended electric vehicle, REEV), a plug-in hybrid electric vehicle (plug-in hybrid electric vehicle, PHEV), a new energy vehicle (new energy vehicle), a fuel vehicle, or the like.

For example, the chip heat dissipation assembly 200 may be used in modules such as an automatic driving module of the vehicle, a module to which a braking system belongs, and a module to which a steering and braking system belongs.

Beneficial effects that can be achieved by the vehicle provided in this embodiment of this application are the same as beneficial effects that can be achieved by the chip heat dissipation assembly 200 provided in any one of the foregoing embodiments. Details are not described herein again.

It may be understood that the chip heat dissipation assembly 200 provided in this embodiment of this application is not only applicable to the vehicle 300 described above, but also applicable to any device that has a heat dissipation requirement for a chip, for example, a mobile phone, a tablet computer, a notebook computer, a smart band, a smart watch, and an intelligent consumer electronic device, or may be a telecommunication equipment room device like a metropolitan area router or a central router, or may be an IT computer room device like a data center server or a data center switch, or may be an in-vehicle device like a mobile data center (mobile data center, MDC), and may also be used in an industrial robot, rail transport (for example, a subway or a high-speed railway), a special power supply (for example, a ship, an aircraft, or a vehicle), or the like. This is not limited in embodiments of this application.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip heat dissipation assembly, comprising:
a circuit board;
a chip, located on the circuit board;
a heat dissipation structure, covering a side that is of the chip and that is away from the circuit board, and connected to the circuit board, wherein the heat dissipation structure comprises a heat dissipation panel, an enclosure part, and a boss part, the enclosure part and the boss part are located on a side that is of the heat dissipation panel and that is close to the chip; both the enclosure part and the boss part are connected to the heat dissipation panel, and the enclosure part is disposed around the boss part; and closed space is enclosed by the heat dissipation panel, the enclosure part, the boss part, and the chip, and there is a gap between the boss part and the chip; and
a thermally conductive medium, filled in the closed space, wherein the thermally conductive medium is in a solid state at a first temperature, and is in a liquid state at a second temperature, and the second temperature is higher than the first temperature.

2. The chip heat dissipation assembly according to claim 1, wherein
the enclosure part comprises a first end face away from the heat dissipation panel, the chip comprises a second end face away from the circuit board, and the first end face is opposite to the second end face.

3. The chip heat dissipation assembly according to claim 2, wherein the enclosure part is disposed around an edge of the second end face.

4. The chip heat dissipation assembly according to any one of claims 1 to 3, wherein in a direction perpendicular to the circuit board, a size of the enclosure part is greater than a size of the boss part.

5. The chip heat dissipation assembly according to any one of claims 1 to 4, wherein the boss part comprises a third end face facing the chip, the third end face comprises a first micro groove, and an extension direction of the first micro groove is parallel to the third end face.

6. The chip heat dissipation assembly according to any one of claims 1 to 5, wherein
the chip comprises the second end face away from the circuit board, the second end face comprises a second micro groove, and an extension direction of the second micro groove is parallel to the second end face.

7. The chip heat dissipation assembly according to any one of claims 1 to 6, further comprising:
a sealing structure, located between the enclosure part and the chip.

8. The chip heat dissipation assembly according to claim 7, wherein the sealing structure is a porous structure, and diameters of a plurality of holes in the sealing structure are greater than a diameter of an air molecule.

9. The chip heat dissipation assembly according to any one of claims 1 to 8, wherein the thermally conductive medium is liquid metal.

10. A vehicle, comprising:
a vehicle body, and
the chip heat dissipation assembly according to any one of claims 1 to 9, wherein the chip heat dissipation assembly is located inside the vehicle body.
